# EUROPEAN PATENT SPECIFICATION

(11) **EP 0 298 933 B1**
(45) Date of publication and mention of the grant of the patent: **09.06.1993**
(21) Application number: 88830295.7
(22) Date of filing: 11.07.1988
(51) Int. Cl.: H01L 39/24, C23C 14/08

(54) **Method for the manufacture of copper oxide superconducting films**
Verfahren zur Herstellung supraleitender Kupferoxid-Schichten
Méthode de fabrication de couches supraconductrices à base d'oxyde de cuivre

(30) Priority: 10.07.1987 IT 2124687
(43) Date of publication of application: 11.01.1989
(73) Proprietor: SAES GETTERS S.P.A., I-20151 Milano (IT)
(72) Inventor: Boffito, Claudio, RHO Milano (IT)
(74) Representative: Adorno, Silvano

(56) References cited:
- PHYSICAL REVIEW B, vol. 35, Third series, no. 16, 1st June 1987, pages 8821-8823, The American Physical Society, New York, US; R.B. LAIBOWITZ et al.: "Thin superconducting oxide films"
- PHYSICAL REVIEW LETTERS, vol. 58, no. 25, 22nd June 1987, pages 2684-2686; P. CHAUDHARI et al.: "Critical-current measurements in epitaxial films of YBa2Cu3O7-x compound"
- APPLIED PHYSICS LETTERS, vol. 51, no. 23, 7th December 1987, pages 1951-1953, American Institute of Physics, New York, US; M. SCHEUERMANN et al.: "Magnetron sputtering and laser patterning of high transition temperature Cu oxide films"

## Description

The present invention relates to a method for the manufacture of superconducting films having a critical temperature, T_{c} greater than 77 K by the utilization of two binary alloy evaporation sources. By "critical temperature" is meant the temperature at which the film becomes super-conducting.

It has recently been found that ceramic materials based on Y-Ba-Cu-O exhibit superconducting properties at temperatures higher than 77 K, the temperature of boiling liquid nitrogen.

Such materials having a high superconducting temperature are very economical as they do not have to be cooled to lower temperatures by means of costly liquid helium.

It would be useful to be able to deposit thin films of superconducting materials as parts of integrated circuits such as conductors between various components or a part of the components themselves such as superconducting quantum interference devices (SQUIDS).

However previously used techniques for deposition of the thin films such as plasma spraying have proved unsatisfactory because of the inability to sufficiently control the film thickness of the deposited film and its exact composition. Furthermore, in cathode sputtering processes it is difficult to use separate sources for each of the three metallic elements as two of these, i.e. Y and Ba, react with air and are subject to deterioration during inevitable handling procedures.

For example, Physical Review Letters, Vol. 58, No. 25 22 June 1987, pages 2684-2686 describes an evaporation method for the manufacture of an epitaxial YBa₂Cu₃O₇₋ₓ film according to which Y, Ba and Cu are evaporated from three separate sources in a vacuum comprising primarily oxygen.

It is therefore an objet of the present invention to provide an improved method of manufacture of a deposited film of a superconducting element having a more carefully controlled film thickness.

It is another object of the present invention to provide an improved method of manufacture of a deposied film of a superconducting element having a more closely controllable composition.

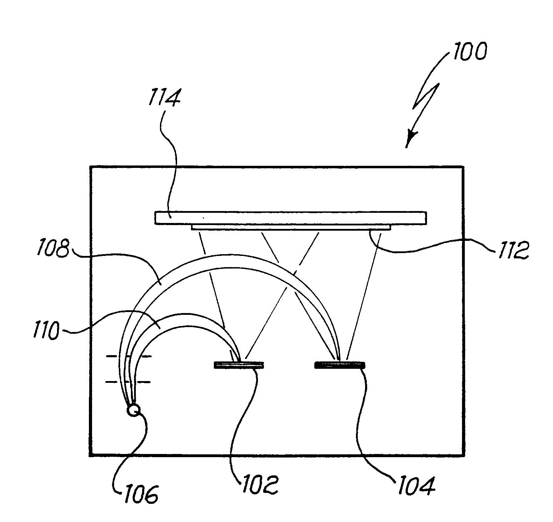

These and other objects of the present invention will become apparent by reference to the following description and the single figure of the drawing wherein:

The drawing shows a respresentation of an evaporation chamber useful in depositing films of the present invention.

According to the present invention there is provided a method for the manufacture of a deposited film of a superconducting element based on Y-Ba-Cu-O and having a critical temperature greater than 77K, comprising the steps of:
I. evaporating the elements Cu and Y from a binary alloy of Cu and Y onto a substrate in an evaporation chamber;
II. simultaneously evaporating the elements Ba and Cu from a binary alloy of Ba and Cu onto the substrate in the same chamber;
both of said evaporation steps I and II taking place either under vacuum followed by subsequent oxidation or directly in a low pressure oxidizing atmosphere in said chamber.

The drawing shows an evaporation chamber 100 containing a first binary alloy source 102 which can conveniently be an intermetallic binary alloy of Cu and Y such as Cu₁Y₁, Cu₂Y, Cu₄Y, Cu₆Y or Cu₇Y.

A second binary alloy source 104 can conveniently be an intermetallic binary alloy of Ba and Cu such as Ba₁Cu₁, Ba₁Cu₃ or Ba₂Cu₃. An electron source 106 provides two electron beams 108, 110 within evacuated chamber 100 which focus onto sources 102 and 104 causing them to evaporate their component elements onto a substrate 112 held on a support 114, in the form of a film 116.

The intensities of electron beams 108, 110 can be varied to suitably adjust the composition of the deposited film 116. The film 116 can then be oxidized by a suitable means or the evaporation can take place directly in a low pressure oxidizing atmosphere.

Other deposition techniques such as by evaporation from the binary alloys by means of laser evaporation or cathode sputtering can be used, for instance in the presence of an argon atmosphere or other techniques well known in the manufacture of semiconductor circuits.

## Claims

1. A method for the manufacture of a deposited film of a superconducting material based on Y-Ba-Cu-O having a critical temperature greater than 77K, characterized by comprising the steps of:
I. evaporating the elements Cu and Y from a binary alloy of Cu and Y onto a substrate in an evaporation chamber;
II. simultaneously evaporating the elements Ba and Cu from a binary alloy of Ba and Cu onto the substrate in the same chamber;
both of said evaporation steps I and II taking place either under vacuum followed by subsequent oxidation or directly in a low pressure oxidizing atmosphere in said chamber.

2. A method according to claim 1 in which the alloy of Cu and Y comprises one or more intermetallic compounds chosen from the group consisting of Cu₁Y₁, Cu₂Y, Cu₄Y, Cu₆Y, Cu₇Y.

3. A method according to claim 1 in which the alloy of Cu and Ba comprises one or more intermetallic compounds chosen from the group consisting of Ba₁Cu₁, Ba₁Cu₃ and Ba₂Cu₃.

## Patentansprüche

1. Verfahren zur Herstellung einer abgeschiedenen Schicht aus einem auf Y-Ba-Cu-O basierenden supraleitenden Material mit einer kritischen Temperatur höher als 77K, dadurch gekennzeichnet, daß es die folgenden Schritte umfaßt:
I. Verdampfen der Elemente Cu und Y aus einer Zweistofflegierung aus Cu und Y auf ein Substrat in einer Bedampfungskammer;
II. Gleichzeitiges Verdampfen der Elemente Ba und Cu aus einer Zweistofflegierung aus Ba und Cu auf das Substrat in der gleichen Kammer;
wobei beide dieser Verdampfungsschritte I und II entweder unter Vakuum mit anschließender Oxidation stattfinden, oder direkt in einer oxidierenden Unterdruckatmosphäre in dieser Kammer.

2. Verfahren nach Anspruch 1, bei dem die Legierung aus Cu und Y ein oder mehrere intermetallische Verbindungen, ausgewählt aus der Gruppe aus Cu₁Y₁, Cu₂Y, Cu₄Y, Cu₆Y, Cu₇Y, umfaßt.

3. Verfahren nach Anspruch 1, bei dem die Legierung aus Cu und Ba ein oder mehrere intermetallische Verbindungen, ausgewählt aus der Gruppe aus Ba₁Cu₁, Ba₁Cu₃ und Ba₂Cu₃, umfaßt.

## Revendications

1. Un procédé pour la fabrication d'une couche mince déposée d'une matière supraconductrice basée sur Y-Ba-Cu-O présentant une température critique supérieure à 77 K, caractérisé en ce qu'il comprend les étapes de :
I. évaporation des éléments Cu et Y à partir d'un alliage binaire de Cu et Y sur un substrat dans une enceinte d'évaporation ;
II. évaporation simultanée des éléments Ba et Cu à partir d'un alliage binaire de Ba et Cu sur le substrat dans la même enceinte ;
lesdites deux étapes d'évaporation I et II étant effectuées soit sous vide suivi par l'oxydation ultérieure, soit directement dans une atmosphère oxydante à basse pression dans ladite enceinte.

2. Un procédé selon la revendication 1, dans lequel l'alliage de Cu et Y comprend un ou plusieurs composants intermétalliques choisis parmi le groupe constitué par Cu₁Y₁, Cu₂Y, Cu₄Y, Cu₆Y, Cu₇Y.

3. Un procédé selon la revendication 1, dans lequel l'alliage de Cu et Ba comprend un ou plusieurs composants intermétalliques choisis parmi le groupe constitué par Ba₁Cu₁, Ba₁Cu₃ et Ba₂Cu₃.
